# EUROPÄISCHE PATENTSCHRIFT

(11) **EP 0 878 020 B1**
(45) Veröffentlichungstag und Bekanntmachung des Hinweises auf die Patenterteilung: **31.10.2001**
(21) Anmeldenummer: 97908130.4
(22) Anmeldetag: 31.01.1997
(51) Int. Cl.: H01J 37/32

(54) **ELEKTROMAGNETISCHES HOCHFREQUENZ- ODER MIKROWELLENGERÄT**
ELECTROMAGNETIC HIGH-FREQUENCY OR MICROWAVE APPARATUS
APPAREIL ELECTROMAGNETIQUE A HAUTE FREQUENCE OU A MICRO-ONDES

(30) Priorität: 02.02.1996 DE 19603685
(43) Veröffentlichungstag der Anmeldung: 18.11.1998
(73) Patentinhaber: Wu, Jeng-Ming, 39106 Magdeburg (DE)
(72) Erfinder: Wu, Jeng-Ming, 39106 Magdeburg (DE)
(74) Vertreter: Lins, Edgar, Dipl.-Phys. Dr.jur.
(86) Internationale Anmeldenummer: DE9700185
(87) Internationale Veröffentlichungsnummer: WO9728555

(56) Entgegenhaltungen:
- EP-A- 0 459 177
- EP-A- 0 501 466
- DE-A- 4 431 785
- PATENT ABSTRACTS OF JAPAN vol. 018, no. 372 (E-1577), 13.Juli 1994 & JP 06 104188 A (HITACHI LTD), 15.April 1994,

## Beschreibung

Die Erfindung betrifft ein elektromagnetisches Hochfrequenz- oder Mikrowellengerät mit einer Behandlungskammer mit einer für die elektromagnetischen Wellen durchlässigen Übertragungswand zu einer benachbarten Kammer, in der die von einem Generator erzeugten elektromagnetischen Wellen geleitet werden, und mit einer Ausbildung der Übertragungswand zur Beeinflussung der Intensitätsverteilung der Übertragung der elektromagnetischen Wellen aus der benachbarten Kammer in die Behandlungskammer.

Es ist bekannt, Mikrowellen, die durch eine Übertragungswand von einer Kammer in eine Behandlungskammer übertragen werden, in ihrer Intensitätsverteilung durch eine spezielle Ausbildung der Übertragungswand zu beeinflussen. Durch DE 94 05 808 U ist ein Plasmabearbeitungsgerät bekannt, bei dem in einer Behandlungskammer durch eingeleitete Mikrowellen ein Plasma, beispielsweise zur Oberflächenbearbeitung von in die Behandlungskammer eingebrachten Gegenständen, erzeugt wird. Dabei werden die Mikrowellen in einem rechteckigen, länglich ausgebildeten Hohlleiter erzeugt und über einen in den Hohlleiter hineinragenden Wellenleiter seitlich ausgekoppelt. Der Wellenleiter ist in diesem Fall scheibenförmig ausgebildet und bildet eine Begrenzungswand für die Behandlungskammer. Zum vergleichmäßigten Einbringen der Mikrowellenenergie in die Behandlungskammer befindet sich zwischen dem Wellenleiter und der Behandlungskammer eine Abschirmung aus leitendem Material, die als Lochblech ausgebildet ist, wobei die Größe der Durchgangslöcher mit zunehmenden Abstand von dem Hohlleiter zunimmt, um so den Abfall der Mikrowellenenergie mit zunehmenden Abstand von dem Hohlleiter ausgleichen zu können.

Das Einsetzen einer derartigen Abschirmung als Übertragungswand der Behandlungskammer führt jedoch zu einem erheblichen Abfall der in die Behandlungskammer eingeleiteten Mikrowellenenergie. Die Vergleichmäßigung der Energieeinleitung in die Behandlungskammer wird daher mit einer erheblichen Reduzierung der Mikrowellenenergie erkauft.

Es ist ferner bekannt, daß ein Plasma in einer Behandlungskammer auch durch Hochfrequenzanregungen erzeugt werden kann.

Durch EP-A-0 459 177 ist eine Mikrowellen-Behandlungskammer bekannt, in der ein Werkstück auf einem Arbeitstisch positionierbar und beispielsweise mit einem durch Mikrowellen erzeugten Plasma oberflächenbeschichtet wird. Zur Erzeugung der erforderlichen Mikrowellenenergie dienen Festkörper-Mikrowellengeneratoren, die jeweils mit einer Antenne verbunden sind, die unmittelbar in die Behandlungskammer hineinragen. Die Mikrowellen zur Anregung des Plasmas werden daher unmittelbar in der Behandlungskammer selbst erzeugt. Dies ist problematisch, weil das Plasma dabei bereits im Bereich der Antennen zündet und auch eine Beschichtung der Antennenelemente stattfindet, wodurch diese in ihrer Funktionsfähigkeit beeinträchtigt werden.

Die Erfindung geht daher - wie eingangs erwähnt - von einem elektromagnetischen Hochfrequenz- oder Mikrowellengerät aus, bei der die elektromagnetischen Wellen von einem Generator außerhalb der Behandlungskammer erzeugt, in einer der Behandlungskammer benachbarten Kammer geleitet werden und über die Übertragungswand in die Behandlungskammer übertragen werden.

Der Erfindung liegt die Problemstellung zugrunde, ein elektromagnetisches Hochfrequenz- oder Mikrowellengerät der eingangs erwähnten Art so auszubilden, daß eine Übertragung der elektromagnetischen Wellen in die Behandlungskammer in einem vorgegebenen Intensitätsprofil oder möglichst gleichmäßig erfolgen kann, ohne daß hierdurch eine erhebliche Herabsetzung der übertragenen elektromagnetischen Energie in Kauf genommen werden muß.

Ausgehend von dieser Problemstellung ist ein elektromagnetisches Hochfrequenz- oder Mikrowellengerät der eingangs erwähnten Art dadurch gekennzeichnet, daß die Übertragungswand eine Vielzahl von winkelig zur Wandebene der benachbarten Kammer gerichtete, in die benachbarte Kammer ragende stabförmige Antennenelemente aufweist, die zentrisch durch von elektrisch leitendem Material begrenzte Durchgangsöffnungen hindurchragen.

Erfindungsgemäß wird die Anregungsenergie aus der benachbarten Kammer in die in diese benachbarte Kammer ragenden Antennenelemente eingekoppelt und von diesen durch die durchlässige Übertragungswand in Richtung Behandlungskammer abgestrahlt. Die Antennenelemente bilden mit den sie umgebenden Durchgangsöffnungen aus elektrisch leitendem Material eine Art Koaxialleiter. Die über das Antennenelement in die Behandlungskammer übertragene elektromagnetische Energie läßt sich durch Einstellung der Koppelungsbedingungen der Antennenelemente zu der Anregungsenergie in der benachbarten Kammer einstellen.

Für die Übertragung von Mikrowellen kann dies in einfacher Weise durch die Länge der Antennenelemente, die aus den Durchgangsöffnungen herausragt, geschehen. Vorzugsweise sind die Durchgangsöffnungen dabei als Durchgangskammern ausgebildet, die unmittelbar oder mit einem Zwischenraum an eine für Mikrowellen durchlässige Platte der Übertragungswand anschließen.

Es ist möglich, die Länge verschiedener Antennenelemente über die Fläche der Übertragungswand unterschiedlich auszubilden, um dadurch, falls erforderlich, eine Vergleichmäßigung oder ein gewünschtes Intensitätsprofil über die Fläche der Übertragungswand auszubilden.

Die Durchgangskammern weisen vorzugsweise an der zur benachbarten Kammer zeigenden Oberfläche des leitenden Materials eine kreisförmige Durchgangsöffnung mit einem Durchmesser auf, der deutlich größer ist als der Durchmesser des Antennenelements. Der Durchmesser der Durchgangsöffnung ist vorzugsweise etwa 2 bis 5 x, weiter bevorzugt etwa 3 x, größer als der Durchmesser des Antennenelements.

Die Durchgangskammer kann sich unterhalb der Durchgangsöffnung stufenförmig erweitern und dort beispielsweise im Querschnitt rund oder rechteckig, vorzugsweise quadratisch, ausgebildet sein.

Durch das Verhältnis von Durchmesser der Durchgangsöffnung zu Durchmessern des Antennenelements läßt sich ebenfalls die Übertragung der Energie über die Übertragungswand steuern.

In einer besonders bevorzugten Ausführungsform sind die Durchgangskammern in einer gemeinsamen elektrisch leitenden Platte ausgebildet.

Die erfindungsgemäße Übertragung durch die Durchgangswand mit Hilfe von Antennenelementen kann auch kaskadiert angewendet werden, indem an die Oberfläche der Durchgangskammern als weitere Durchgangskammern ausgebildete Kopplungskammern angeschlossen sind, die zentrisch jeweils ein Koppel-Antennenelement aufweisen und in die mehrere Antennenelemente der Durchgangskammern hineinragen. Zweckmäßigerweise wird eine derartige Anordnung mit zwei flächig aneinanderliegeden Metallplatten ausgebildet, wobei die Anzahl der Antennenelemente ein Vielfaches der Anzahl der Koppel-Antennenelemente beträgt. Auch die Koppelkammern sind dabei vorzugsweise an ihre zur benachbarten Kammer zeigenden Oberfläche mit einer kreisrunden Durchgangsöffnung versehen, mit deren Dimensionierung relativ zum Durchmesser eines Koppel-Antennenelements die Energieübertragung steuerbar ist. In ähnlicher Weise wie mit den Antennenelementen kann auch durch die Länge der Koppel-Antennenelemente die Energieübertragung beeinflußt werden.

Vorzugsweise weist die benachbarte Kammer als Übertragungskammer eine parallel zur Übertragungswand verlaufende Längsachse und wenigstens einen parallel zur Längsachse gerichteten Wellenleiter zur Einkopplung von Mikrowellen in die benachbarte Kammer auf.

Der Wellenleiter kann dabei vorzugsweise stabförmig ausgebildet sein und durch eine Öffnung einer Trennwand in einen Hohlraumresonator ragen, dessen Längsachse senkrecht zur Längsachse der Übertragungskammer steht.

Der Wellenleiter endet mit Abstand von der dem Hohlraumresonator gegenüberliegenden elektrisch wirksamen Stirnwand. Vorzugsweise ist mit einem verschiebbaren leitenden Stempel der Abstand der elektrisch wirksamen Stirnwand zum Wellenleiter veränderbar. Dadurch wird dem Umstand Rechnung getragen, daß durch die Veränderung der Länge der Antennenelemente die Resonanzbedingungen in der Übertragungskammer stark verändert werden, was durch Verschiebung des leitenden Stempel als elektrisch wirkende Stirnwand kompensierbar ist.

Es ist auch möglich, in der Übertragungskammer mehrere Wellenleiter parallel zu einander anzuordnen und den Wellenleitern durch leitende Zwischenwände Abteilungen zuzuordnen. Dadurch wird bereits eine vergleichmäßigte Einkopplung der Mikrowellenenergie in die Übertragungskammer bewirkt. Zweckmäßigerweise werden jedem Wellenleiter innerhalb der Abteilungen symmetrische Anordnungen von Antennenelementen der Übertragungswand zugeordnet. Innerhalb der einzelnen Abteilungen ist dabei zweckmäßigerweise jeweils ein als Stirnwand wirkender Stempel verschiebbar angeordnet.

Für eine Anregung des Plasmas mit Hochfrequenzenergie (im allgemeinen MHz-Bereich unterhalb der Mikrowellenfrequenz) ist es vorteilhaft, wenn die Antennenelemente abgewinkelt sind und mit einem abgewinkelten Ende im wesentlichen parallel zu dem Innenleiter eines in der benachbarten Kammer ausgebildeten Koaxialleiters verlaufen und mit dem anderen Ende durch die Durchgangswand hindurch in die Behandlungskammer ragen und dort mit Abstand zu einer gemeinsamen, auf dem Potential des Außenleiters liegenden Gegenelektrode angeordnet sind. Zweckmäßigerweise können dabei die durch die Durchgangswand ragenden Antennenelemente parallel zur Gegenelektrode ausgebildete Endstücke aufweisen. Auch hierbei bilden die Antennenelemente zweckmäßigerweise mit Durchgangskammern aus leitendem Material einen Koaxialleiterabschnitt, durch den die Übertragung der Hochfrequenzenergie gut gelingt. Durch Auswahl des Abstands und der Länge des abgewinkelten Endes des Antennenelements zum Koaxialleiter kann die Einkoppelbedingung ausgewählt und die Größe der an der Stelle des jeweiligen Antennenelements übertragenen Anregungsenergie eingestellt werden.

Die Behandlungskammer ist vorzugsweise als Vakuumkammer ausgebildet, wobei die Anordnung vorzugsweise als Plasma-Behandlungsanordnung verwendet wird. Innerhalb der Behandlungskammer dann dabei ein Behandlungstisch in an sich bekannter Weise höhenverstellbar ausgebildet sein.

Insbesondere für hohe Vakua kann es zweckmäßig sein, daß an der Außenseite des Behandlungsraumes Spulenanordnungen zur Ausbildung eines Magnetfeldes vorgesehen sind, um durch den Einfluß des Magnetfeldes die Kollisionswahrscheinlichkeit zwischen Gaspartikeln zu erhöhen und damit die Zündungsfähigkeit des Plasmas zu verbessern. Dabei kann es zweckmäßig sein, unter dem Behandlungstisch eine Mehrzahl von Permanentmagneten anzuordnen.

Für bestimmte Anwendungen im Plasma kann es zweckmäßig sein, zwischen dem Behandlungstisch und der Übertragungswand ein negativ geladenes Sieb als Elektronenfalle anzuordnen, durch das zur Plasmabehandlung nur Ionen hindurchtreten.

Die Erfindung soll im folgenden anhand von in der Zeichnung dargestellten Ausführungsbeispielen näher erläutert werden. Es zeigen:
- Figur 1 -: einen Vertikalschnitt durch ein erfindungsgemäßes Mikrowellengerät
- Figur 2 -: eine perspektivische Ansicht einer mit Durchgangskammern versehenen Metallplatte mit zentrisch eingesezten Antennenelementen
- Figur 3 -: eine schematische Ansicht der Unterseite der Metallplatte gemäß Figur 2 ohne Antennenelemente
- Figur 4 -: eine perspektivische schematische Darstellung des Mikrowellengeräts gemäß Figur 1
- Figur 5 -: einen Horizontalschnitt durch eine Übertragungskammer mit mehreren, parallel zueinander angeordneten Wellenleitern
- Figur 6 -: eine schematische Darstellung einer Übertragungswand mit kaskadierten Antennenelementen und Durchgangskammern
- Figur 6a -: eine Variante der Ausführungsform gemäß Figur 6
- Figur 7 -: eine Anordnung gemäß Figur 1 mit einer Elektonenfalle in der Behandlungskammer und Anregungsspulen für ein Magnetfeld
- Figur 8 -: eine Anordnung gemäß Figur 1 mit einer Spulenanordnung zur Erzeugung eines Magnetfelds sowie mit einer Anordnung von Permanentmagneten unterhalb des Behandlungstisches
- Figur 9 -: eine Variante der Ausbildung der Übertragungswand zu der Ausführungsform gemäß Figuren 1, 7 und 8
- Figur 10 -: eine weitere Variante der Übertragungswand
- Figur 11 -: eine noch andere Variante der Übertragungswand
- Figur 12 -: eine schematische Darstellung eines für Hochfrequenzanregung ausgelegten erfindungsgemäßen Behandlungsgeräts.

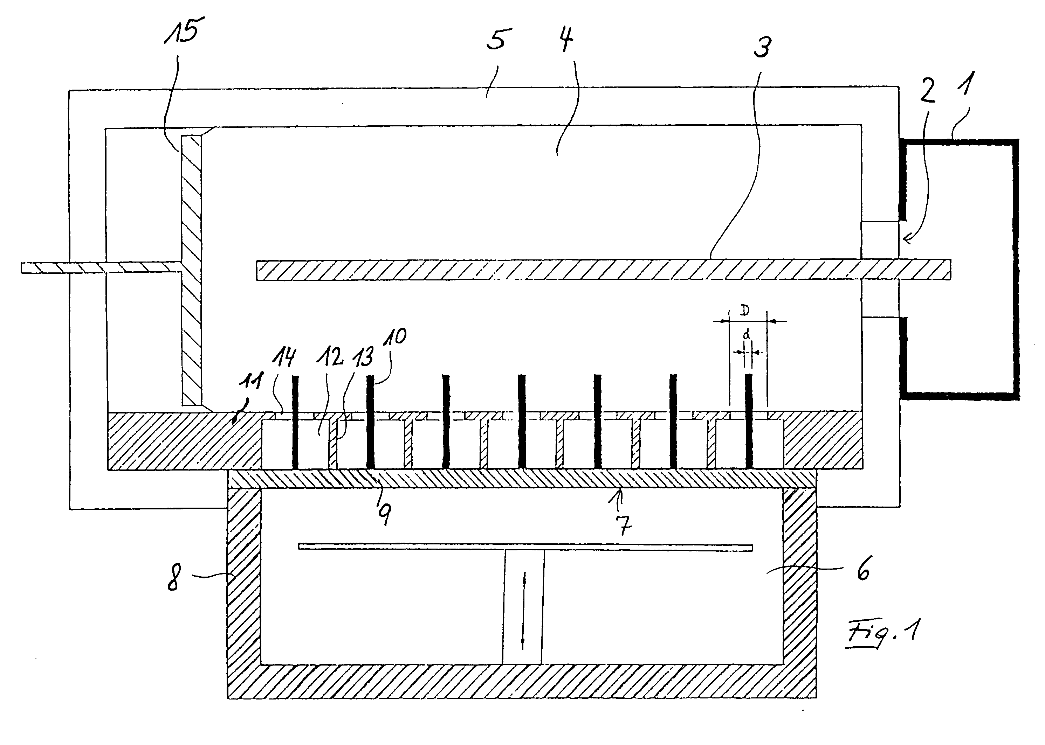

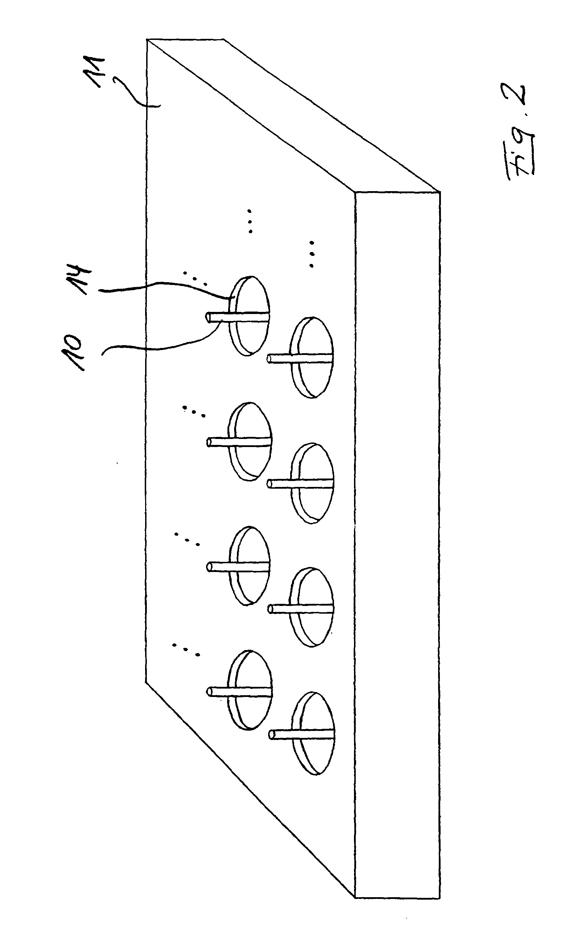

Figur 1 zeigt eine Anordnung, in der in einem Hohlleiter 1 mit einem rechteckigen Querschnitt Mikrowellen erzeugt werden. Die Mikrowellen werden durch eine seitliche Öffnung 2 des Hohlleiters 1 mit Hilfe wenigstens eines stabförmigen Wellenleiters 3 ausgekoppelt und in eine Übertragungskammer 4 eingeleitet. Die Übertragungskammer 4 wird im wesentlichen von metallischen Wänden 5 begrenzt. In eine an einer Längsseite der rechteckigen Übertragungskammer 4 befindliche Ausnehmung ragt eine Behandlungskammer 6, die allseitig mit Ausnahme der zur benachbarten Übertragungskammer 4 zeigenden Wand 7 durch metallische Wände 8 begrenzt ist. Die Behandlungskammer 6 ist als Vakuumkammer ausgeführt. Die Übertragungswand 7 besteht aus einer für Mikrowellen durchlässigen Platte 9, einer Vielzahl von senkrecht zu der durchlässigen Platte 9 sich in die Übertragungskammer 4 erstreckenden Antennenelementen 10 sowie einer sich über die gesamte Längsseite der Übertragungskammer 4 erstreckenden metallischen Platte 11. In der metallischen Platte 11 sind Durchgangskammern 12 ausgebildet, die zur durchlässigen Platte 9 hin offen sind und somit von dieser begrenzt werden. Seitlich werden die quadratischen Durchgangskammern durch gitterförmig ausgebildete dünne Wände 13 der metallischen Platte 11 begrenzt. An der Oberfläche befindet sich eine kreisförmige Durchgangsöffnung 14 etwa in der Dicke der Wände 13, wobei die Durchgangsöffnungen 14 einen Durchmesser D aufweisen, der zwischen 2 und 5 x so groß ist wie der Durchmesser d der Antennenelemente 10, die zentrisch in der Durchgangsöffnung 14 und in der Durchgangskammer 12 angeordnet sind.

Die Antennenelemente 10 ragen um ein gewisses Maß über die metallische Platte 11 in die Übertragungskammer 4 hinein, wobei durch die Länge der Antennenelemente die Menge der eingekoppelten Mikrowellenenergie beeinflußbar ist.

Vorzugsweise werden die Antennenelemente 10 in unterschiedlichen Längen auf Lager gehalten und werden versuchsweise in unterschiedlichen Längen eingesetzt, um eine optimierte Konstellation zu erzielen. Durch den Übergang auf ein Antennenelement 10 mit einer anderen Länge wird die Resonanzbedingung in der Übertragungskammer 4 sofort dramatisch verändert. Um hier jeweils Anpassungen vornehmen zu können, ist die Übertragungskammer 4 auf der dem Hohlleiter 1 gegenüberliegenden Seite mit einem verschiebbaren metallischen Stempel 15 versehen, mit dem empirisch wieder eine optimale Resonanzbedingung in der Übertragungskammer 4 einstellbar ist.

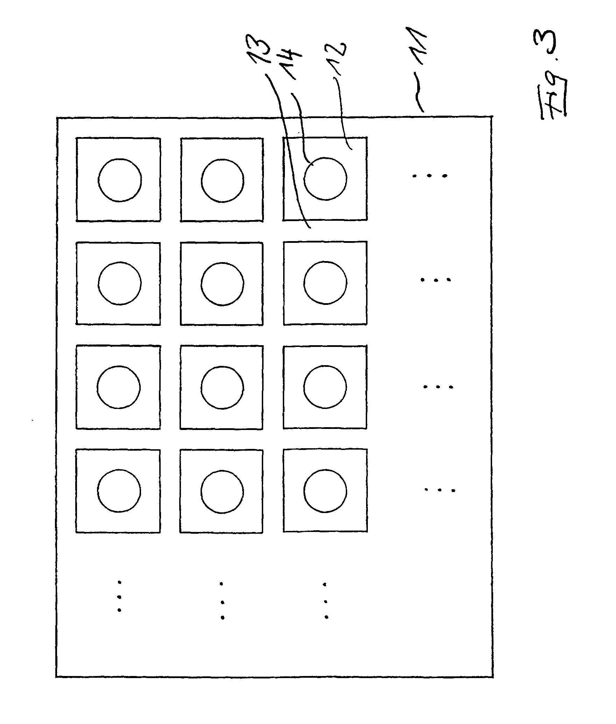

Figur 2 läßt die metallische Platte 11 mit ihren kreisförmigen Durchgangsöffnungen 14 an der Oberfläche erkennen. In die kreisförmigen Durchgangsöffnungen 14 sind die stabförmigen Antennenelemente 10 zentrisch eingesetzt.

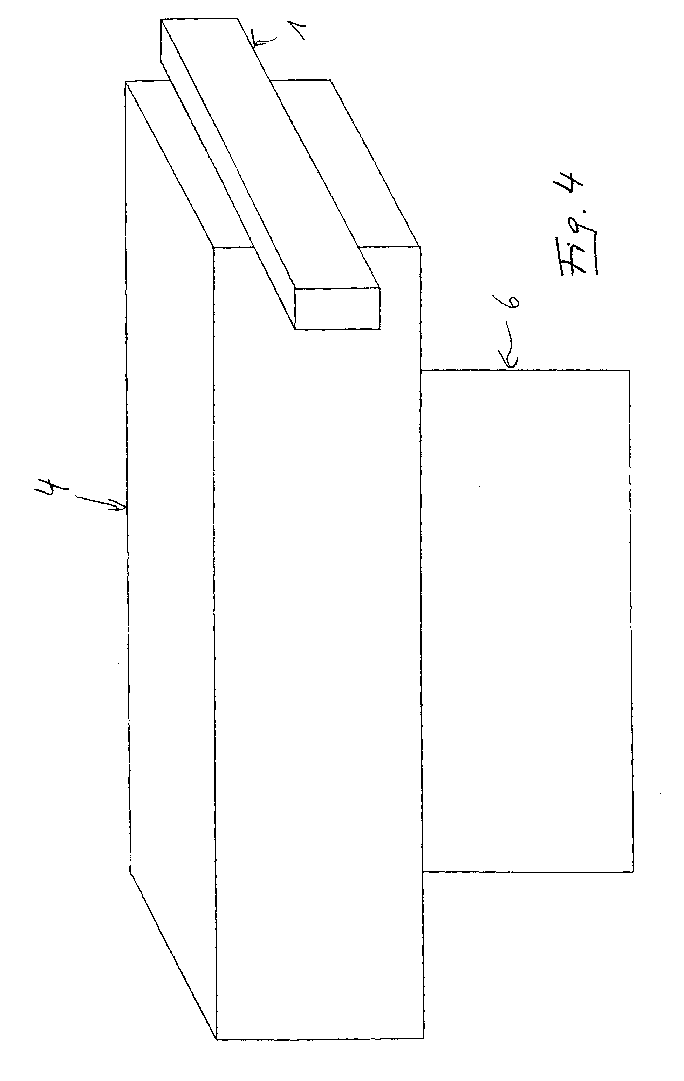

Die Ansicht auf die Unterseite der metallischen Platte 11 gemäß Figur 3 verdeutlicht, daß die Durchgangskammern 12 einen quadratischen Querschnitt aufweisen und sich unterhalb der Durchgangsöffnung 14 stufenförmig erweitern. Die Durchgangskammern 12 werden durch die gitterförmig ausgebildeten Wände 13 begrenzt.

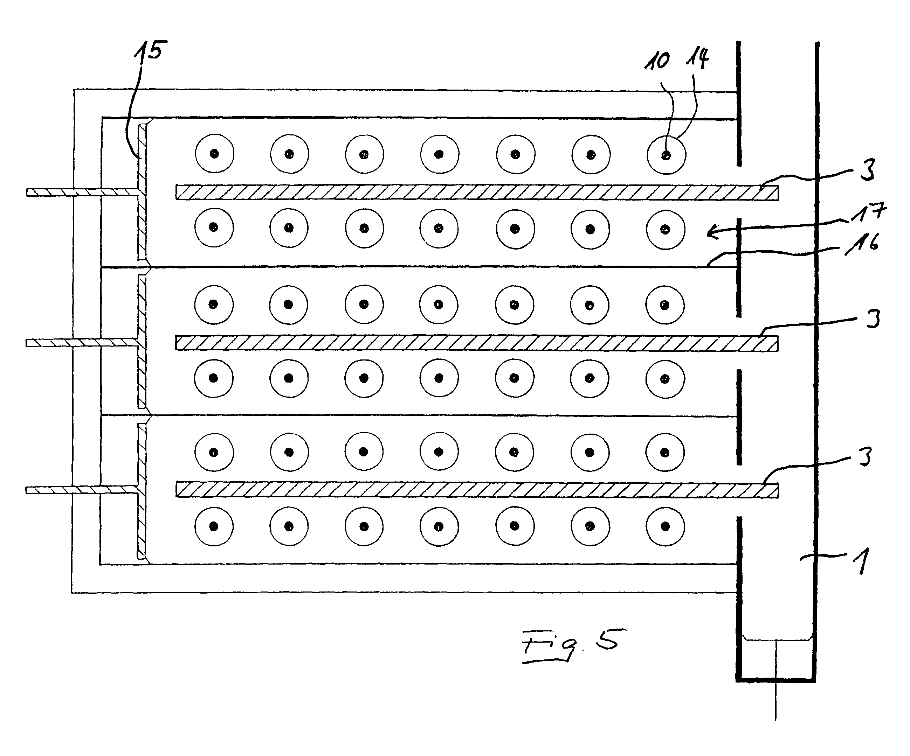

Figur 4 läßt die schematische Anordnung von Hohlleiter 1, Übertragungskammer 4 und Behandlungskammer 6 erkennen, die alle jeweils quaderförmig ausgebildet sind.

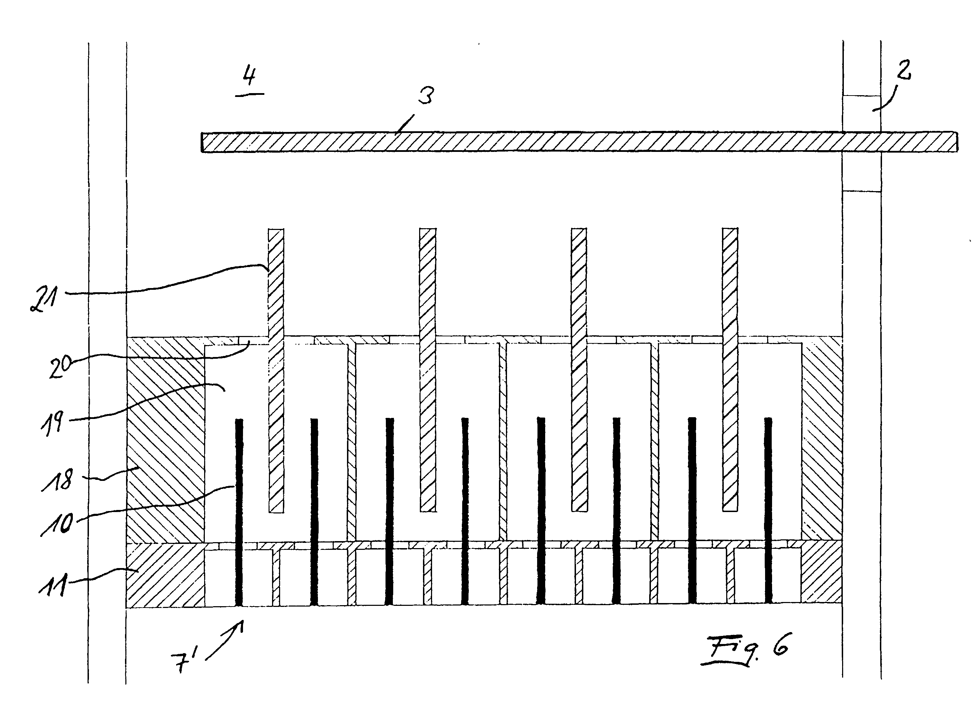

Figur 5 zeigt ein modifiziertes Ausführungsbeispiel, bei dem in den Hohlleiter drei Wellenleiter 3 in zueinander und zur Übertragungswand 7 parallelen Anordnungen hineinragen und sich über die Länge der Übertragungskammer 4 erstrecken. Figur 5 läßt erkennen, daß jedem Wellenleiter 3 beidseitig jeweils eine Reihe von kreisförmigen Durchgangsöffnungen 14 mit Antennenelementen 10 zugeordnet sind, wobei die symmetrische Anordnung zu beiden Seiten des Wellenleiters 3 wesentlich ist. Durch leitende Zwischenwände 16 werden für jeden Wellenleiter 3 Abteilungen gebildet, durch die eine gegenseitige Beeinflussung der Antennenelemente 10 durch mehrere Wellenleiter 3 ausgeschlossen wird.

Für jede Abteilung 17 ist ein verschiebbarer Stempel 15 als elektrisch wirksame Stirnwand vorgesehen.

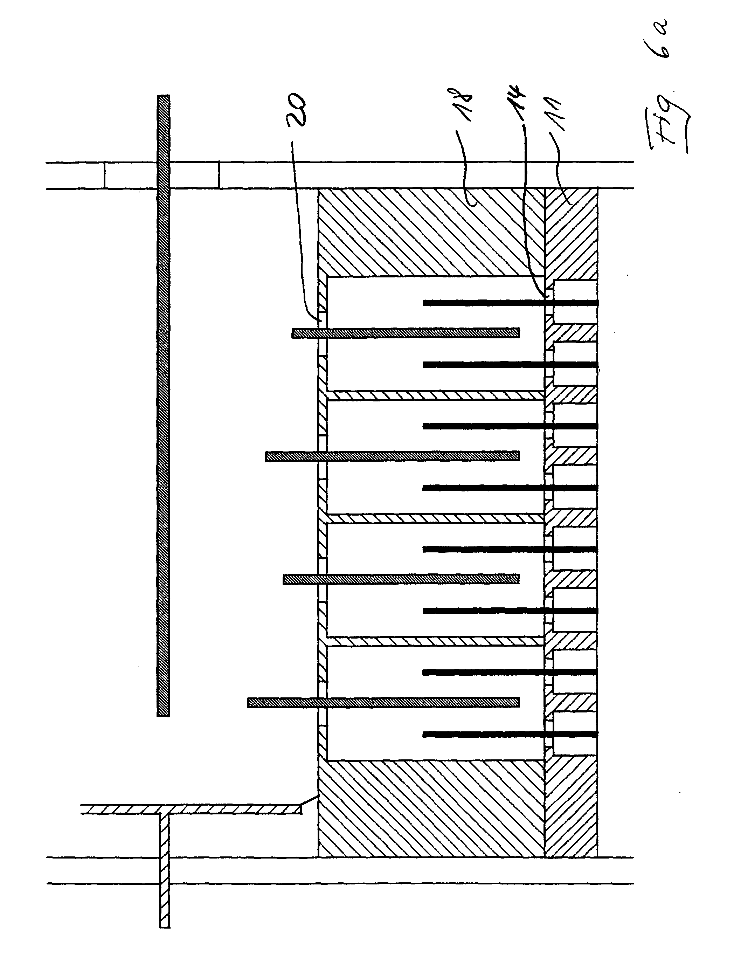

Figur 6 verdeutlicht eine kaskadierte Ausbildung der Übertragungswand 7'. Auf die metallische Platte 11 ist dabei eine weitere metallische Platte 18 gesetzt, die mit ähnlichen Durchgangskammern 19 und kreisförmigen Durchgangsöffnungen 20 versehen sind. In die Durchgangskammer 19 und die Durchgangsöffnung 20 ist zentrisch ein Koppel-Antennenelement 21 eingesetzt, das aus der Durchgangskammer 19 in die Übertragungskammer 4 hineinragt und naturgemäß mit einem Abstand von der Oberfläche der metallischen Platte 11 endet.

Es ist erkennbar, daß mehrere Antennenelemente 10 in die Durchgangskammer 19 hineinragen, beispielsweise vier Antennenelemente 10 in symmetrischer Anordnung zum zentrischen Koppel-Antennenelement 21. Der Vorteil dieser Anordnung besteht darin, daß eine gleichmäßige Übertragung der Mikrowellenenergie durch die zahlreichen Antennenelemente 10 bewirkt wird, daß jedoch die Justierungsarbeiten nur mit den Koppel-Antennenelementen 21 (insbesondere mit deren Länge) durchgeführt werden müssen, während die Antennenelemente 10 mit gleicher Länge ausgebildet sein können, also nicht mehr justiert werden müssen (Figur 6a). Die Justierung der wesentlich geringeren Anzahl der Koppel-Antennenelemente 21 ist aber ausreichend, um homogenen Übertragungen aus der Übertragungskammer 4 Rechnung zu tragen.

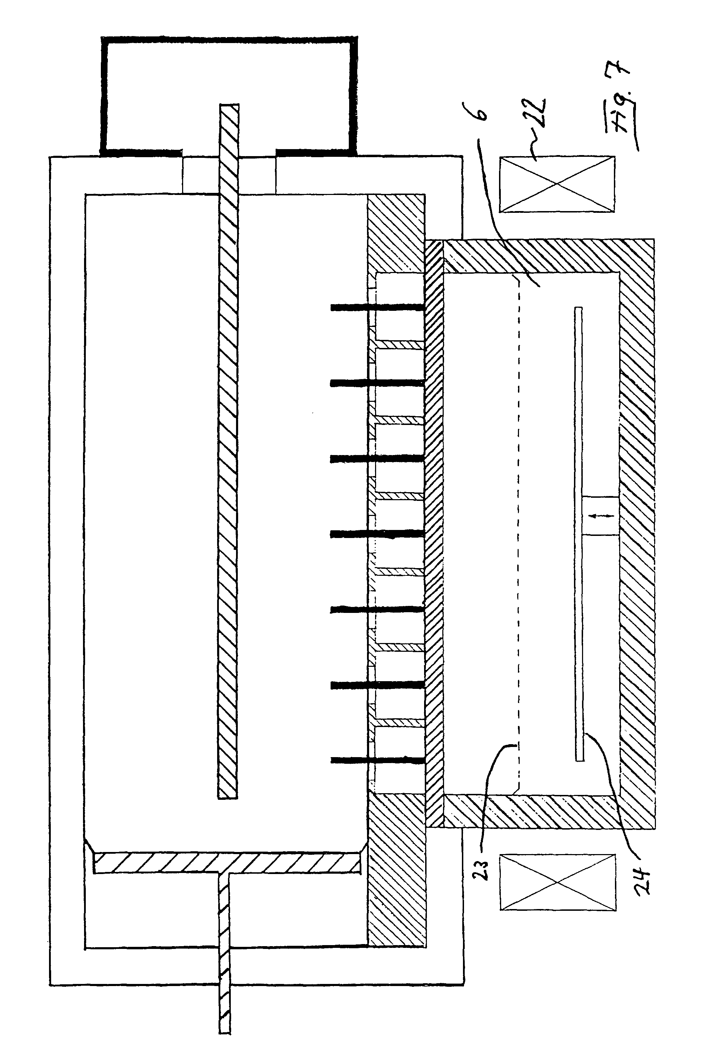

Figur 7 zeigt die Anordnung gemäß Figur 1, wobei jedoch um die Behandlungskammer 6 herum eine Spulenanordnung 22 zur Ausbildung eines Magnetfeldes in der Behandlungskammer 6 vorgesehen ist. Durch das Magnetfeld wird die Zahl der Kollisionen zwischen Gaspartikeln deutlich erhöht, so daß auch bei einem hohen Vakuum eine Plasmazündung erreicht werden kann.

Außerdem ist die Behandlungskammer 6 mit einem siebförmigen Gitter 23 zwischen der Übertragungswand 7 und einem Behandlungstisch 24 versehen. Das Gitter 23 wird negativ vorgespannt, so daß es Elektronen abfängt und nur Ionen durchläßt. Auf diese Weise dient die Anordnung als Ionenquelle zur Behandlung von auf den Behandlungstisch 24 aufgesetzten Produkten.

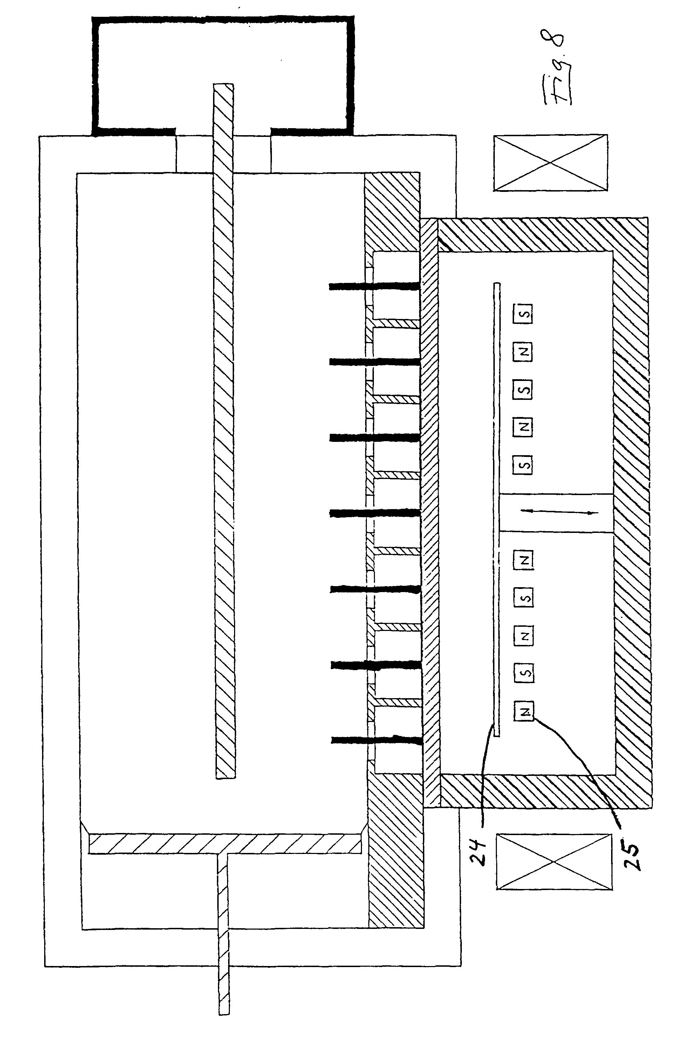

Bei der in Figur 8 dargestellten Ausführungsform befindet sich unterhalb des Behandlungstisches eine Anordnung aus zahlreichen Permanentmagneten 25, die abwechselnd gepolt sind. Hierdurch wird eine lokale Verdichtung des Plasmas erreicht, die die Zündung des Plasmas begünstigt.

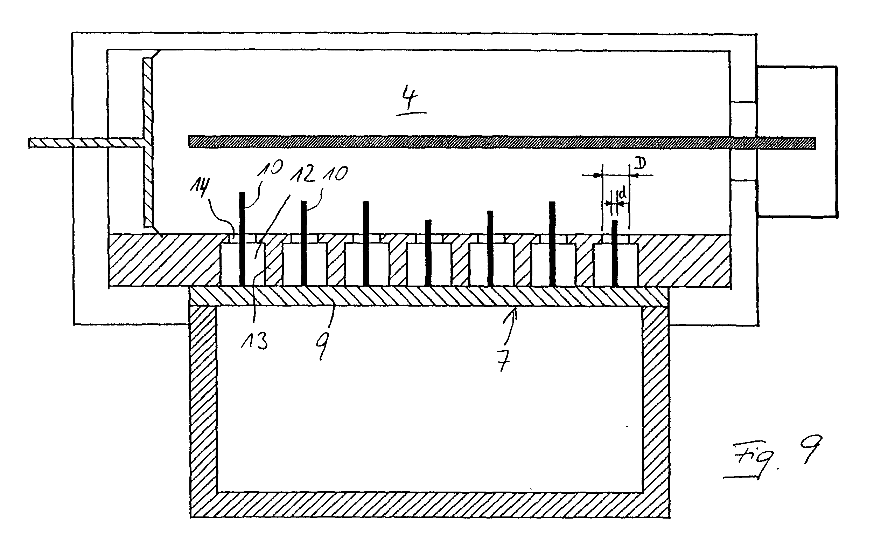

Bei der in Figur 9 dargestellten Ausführungsform sind die Antennenelemente 10 mit unterschiedlichen Längen ausgebildet und enden alle an der für Mikrowellen durchlässigen Platte 9 der Übertragungswand 7. Die Antennenelemente ragen mit unterschiedlichen Längen aus den Durchgangsöffnungen 14 heraus. Durch die herausstehende Länge der Antennenelemente läßt sich die Einkopplung der in die Kammer 4 eingeleiteten Mikrowellenenergie in die Antennenelemente 10 regulieren. Im übrigen befinden sich die Antennenelemente 10 in Durchgangskammern 12, die durch die Wände 13 begrenzt sind.

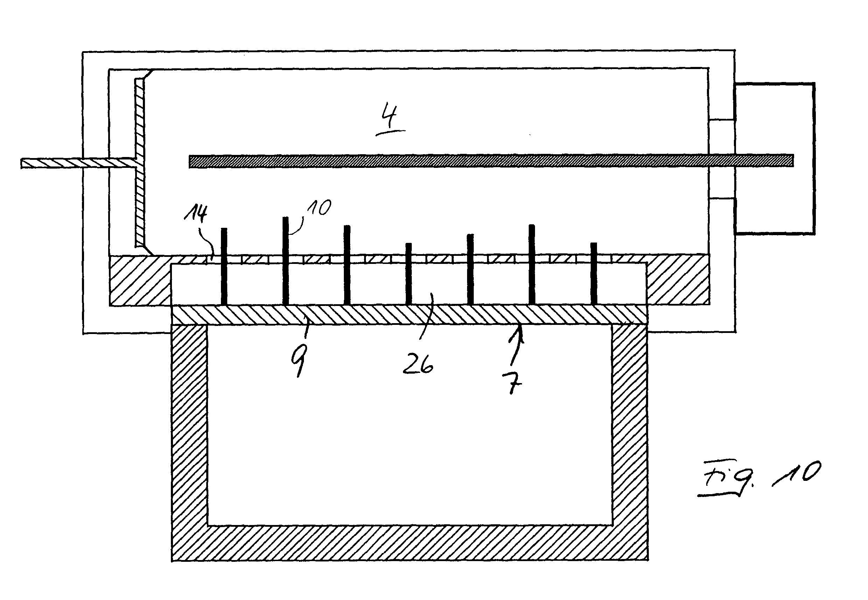

Bei der in Figur 10 dargestellten Ausführungsform ragen die Antennenelemente 10 in Richtung der Kammer 4 mit unterschiedlichen Längen aus den Durchgangsöffnungen 14 heraus, verlaufen jedoch zwischen den Durchgangsöffnungen 14 und der mikrowellendurchlässigen Platte 9 der Übertragungswand 7 in einem gemeinsamen Zwischenraum 26, der dadurch entsteht, daß die Zwischenwände 13 gemäß den in den Figuren 1, 7, 8 und 9 dargestellten Ausführungsbeispielen entfallen sind.

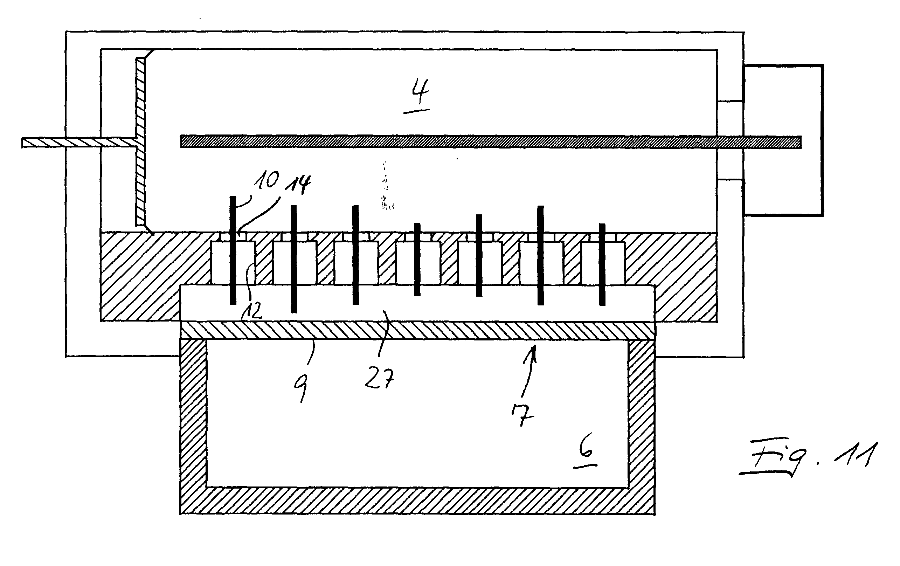

Figur 11 zeigt ein Ausführungsbeispiel, bei dem die Antennenelemente 10 durch Durchgangsöffnungen 14 und Durchgangskammern 12 hindurchgeführt sind, wobei jedoch zwischen den Durchgangskammern 12 und der für Mikrowellen durchlässigen Platte 9 der Übertragungswand 7 ein gemeinsamer Zwischenraum 27 ausgebildet ist, in den gemäß diesem Ausführungsbeispiel die Antennenelemente 10 ebenfalls mit unterschiedlichen Längen hineinragen. Auf diese Weise läßt sich nicht nur die in die Antennenelemente aus der Kammer 4 eingekoppelte Mikrowellenenergie, sondern auch die in die Behandlungskammer 6 abgestrahlte Mikrowellenenergie steuern.

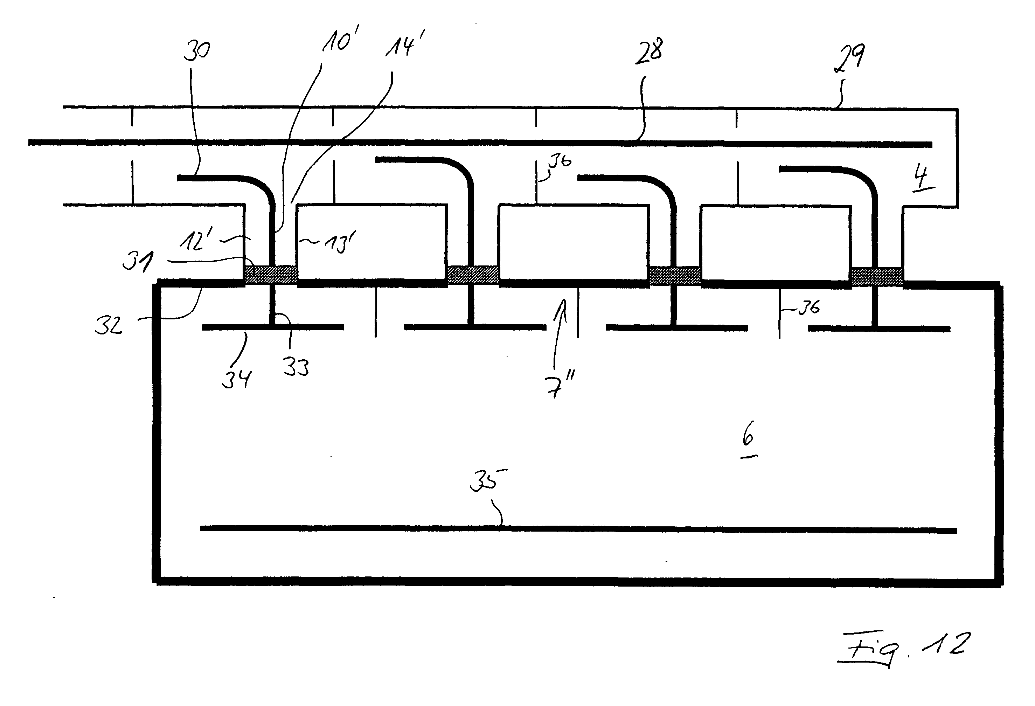

Figur 12 zeigt eine schematische Darstellung einer Anregung des Plasmas in der Behandlungskammer 6 durch elektromagnetische Hochfrequenzenergie, deren Frequenz also unterhalb der Mikrowellenfrequenz liegt. Hierzu ist die benachbarte Kammer 4 als eine Art Koaxialleiter mit einem sich über die Länge der Kammer 4 erstreckenden Innenleiter 28 und einem den Innenleiter 28 mit Abstand umgebenden rechteckigen Gehäuse 29 aus elektrisch leitendem Material ausgebildet.

Antennenelemente 10' stehen ebenfalls senkrecht zu einer Übertragungswand 7" zwischen der benachbarten Kammer 4 und der Behandlungskammer 6. Innerhalb der benachbarten Kammer 4 weisen die Antennenelemente 10' abgewinkelte Enden 30 auf, die im wesentlichen parallel zu dem Innenleiter 28 verlaufen. Die Antennenelemente 10' sind durch Durchgangskammern 12' hindurchgeführt, die durch elektrisch leitende Wände 13' begrenzt sind.

Innerhalb der Durchgangskammern 12' befinden sich Abdichtungsstücke 31 aus dielektrischem Material, die die Hochfrequenzleitung nicht beeinträchtigen. Die Abdichtungsstücke 31 verlaufen im wesentlichen fluchtend mit die Behandlungskammer 6 begrenzenden Wandungen 32 aus elektrisch leitendem Material. Die Antennenelemente 10' sind durch die Abdichtungsstücke 31 hindurchgeführt und ragen mit Enden 33 in die Behandlungskammer 6 hinein. An den Enden 33 sind Endstücke 34 angeformt, die im wesentlichen parallel zu einer auf Massepotential liegenden gemeinsamen Gegenelektrode 35 verlaufen.

Zur Verminderung der gegenseitigen Beeinflussung der Antennenelemente 10' befinden sich sowohl innerhalb der Kammer 4 als auch innerhalb der Behandlungskammer 6 Abteilungswände 36, die die Enden 30 und 34 der Antennenelemente 10' voneinander abschirmen.

In der durch die Wandungen 32 und die Dichtungsstücke 31 gasdicht abgeschlossenen Behandlungskammer 6 wird ein Plasma durch Hochfrequenzanregung erzeugt, wobei eine Vergleichmäßigung des Plasmas bzw. ein gewünschtes Energieprofil durch die Art der Einkopplung von Hochfrequenzenergie in die Antennenelemente 10' über die abgebogenen Enden 30 einstellbar ist.

## Patentansprüche

1. Elektromagnetisches Hochfrequenz- oder Mikrowellengerät mit einer Behandlungskammer (6) mit einer für die elektromagnetischen Wellen durchlässigen Übertragungswand (7, 7', 7'') zu einer benachbarten Kammer (4), in der die von einem Generator erzeugten elektromagnetischen Wellen geleitet werden, und mit einer Ausbildung der Übertragungswand (7, 7', 7'') zur Beeinflussung der Intensitätsverteilung der Übertragung der elektromagnetischen Wellen aus der benachbarten Kammer (4) in die Behandlungskammer (6), **dadurch gekennzeichnet, daß** die Übertragungswand (7, 7', 7'') eine Vielzahl von winkelig zur Wandebene der benachbarten Kammer (4) gerichteten, in die benachbarte Kammer (4) ragenden stabförmigen Antennenelementen (10, 10') aufweist, die zentrisch durch von elektrisch leitendem Material begrenzte Durchgangsöffnungen (14, 14') hindurchragen.

2. Mikrowellengerät nach Anspruch 1, **dadurch gekennzeichnet, daß** die Übertragungswand (7, 7') eine für Mikrowellen durchlässige Platte (9) und eine Platte (11) aus elektrisch leitendem Material aufweist, in der sich die Durchgangsöffnungen (14) befinden.

3. Mikrowellengerät nach Anspruch 2, **dadurch gekennzeichnet, daß** zwischen den Durchgangsöffnungen (14) und der für Mikrowellen durchlässigen Platte (9) ein gemeinsamer Zwischenraum (26) ausgebildet ist.

4. Mikrowellengerät nach Anspruch 2, **dadurch gekennzeichnet, daß** zwischen Durchgangsöffnungen (14) und der für Mikrowellen durchlässigen Platte (9) Durchgangskammern (12) ausgebildet sind.

5. Mikrowellengerät nach Anspruch 4, **dadurch gekennzeichnet, daß** zwischen den Durchgangskammern (12) und der für Mikrowellen durchlässigen Platte (9) ein gemeinsamer Zwischenraum (27) ausgebildet ist.

6. Mikrowellengerät nach einem der Ansprüche 2 bis 5, **dadurch gekennzeichnet, daß** die Antennenelemente (10) senkrecht zur durchlässigen Platte (9) stehen.

7. Mikrowellengerät nach einem der Ansprüche 4 oder 5, **dadurch gekennzeichnet, daß** die Durchgangskammern (12) an der zur benachbarten Kammer (4) zeigenden Oberfläche des leitenden Materials (11) eine kreisförmige Durchgangsöffnung (14) mit einem Durchmesser (D) aufweisen, der größer ist als der Durchmesser (d) des Antennenelements (10).

8. Mikrowellengerät nach Anspruch 7, **dadurch gekennzeichnet, daß** der Durchmesser (D) der Durchgangsöffnung (14) etwa 2 bis 5, vorzugsweise etwa 3 x größer ist als der Durchmesser (d) des Antennenelements (10).

9. Mikrowellengerät nach Anspruch 7 oder 8, **dadurch gekennzeichnet, daß** sich die Durchgangskammern (12) anschließend an die Durchgangsöffnung (14) zur durchlässigen Platte (9) hin stufenförmig erweitern.

10. Mikrowellengerät nach einem der Ansprüche 7 bis 9, **dadurch gekennzeichnet, daß** die Durchgangskammer (12) anschließend an die Durchgangsöffnung (14) einen rechteckigen, vorzugsweise quadratischen Querschnitt aufweist.

11. Mikrowellengerät nach einem der Ansprüche 4 bis 10, **dadurch gekennzeichnet, daß** die Durchgangskammern (12) in einer gemeinsamen elektrisch leitenden Platte (11) ausgebildet sind.

12. Mikrowellengerät nach einem der Ansprüche 4 bis 11, **dadurch gekennzeichnet, daß** die Antennenelemente (10) aus der Oberfläche der Durchgangskammern (12) herausragen.

13. Mikrowellengerät nach einem der Ansprüche 1 bis 12, **dadurch gekennzeichnet, daß** die Länge verschiedener Antennenelemente (10) über die Fläche der Übertragungswand (7) unterschiedlich ausgebildet ist.

14. Mikrowellengerät nach einem der Ansprüche 4 bis 13, **dadurch gekennzeichnet, daß** an die Durchgangsöffnungen (14) als weitere Durchgangskammern ausgebildete Kopplungskammern (19) angeschlossen sind, die zentrisch jeweils ein Koppel-Antennenelement (21) aufweisen und in die mehrere Antennenelemente (10) hineinragen.

15. Mikrowellengerät nach Anspruch 14, **dadurch gekennzeichnet, daß** auch die Kopplungskammern (19) an ihrer zur benachbarten Kammer (4) zeigenden Oberfläche eine kreisrunde Durchgangsöffnung (20) aufweisen.

16. Mikrowellengerät nach Anspruch 15, **dadurch gekennzeichnet, daß** die Koppel-Antennenelemente (21) mit unterschiedlichen Längen ausgebildet sind und aus ihren Durchgangsöffnungen (20) herausragen.

17. Mikrowellengerät nach einem der Ansprüche 1 bis 16, **dadurch gekennzeichnet, daß** die benachbarte Kammer (4) als Übertragungskammer eine parallel zur Übertragungswand (7) verlaufende Längsachse und wenigstens einen parallel zur Längsachse gerichteten Wellenleiter (3) zur Einkopplung von Mikrowellen in die Übertragungskammer (4) aufweist.

18. Mikrowellengerät nach Anspruch 17, **dadurch gekennzeichnet, daß** der Wellenleiter (3) stabförmig ausgebildet ist und durch eine Öffnung (2) einer Trennwand in einen Hohlleiter (1) ragt, dessen Längsachse senkrecht zur Längsachse der Übertragungskammer (4) steht.

19. Mikrowellengerät nach Anspruch 17 oder 18, **dadurch gekennzeichnet, daß** der Wellenleiter (3) mit Abstand von der dem Hohlleiter (1) gegenüberliegenden Stirnwand endet und daß mit einem verschiebbaren leitenden Stempel (15) der Abstand zur elektrisch wirksamen Stirnwand veränderbar ist.

20. Mikrowellengerät nach einem der Ansprüche 17 bis 19, **dadurch gekennzeichnet, daß** mehrere Wellenleiter (3) parallel zueinander in die Übertragungskammer (4) ragen und daß den Wellenleitern (3) durch leitende Zwischenwände (16) Abteilungen (17) zugeordnet sind.

21. Mikrowellengerät nach Anspruch 20, **dadurch gekennzeichnet, daß** innerhalb der Abteilungen (17) jedem Wellenleiter (3) symmetrische Anordnungen von Antennenelementen (10) zugeordnet sind.

22. Mikrowellengerät nach Anspruch 20 oder 21, **dadurch gekennzeichnet, daß** innerhalb der Abteilungen (17) jeweils ein als Stirnwand wirkender Stempel (15) verschiebbar angeordnet ist.

23. Hochfrequenzgerät nach Anspruch 1, **dadurch gekennzeichnet, daß** die Antennenelemente (10') abgewinkelt sind und mit einem abgewinkelten Ende (30) im wesentlichen parallel zu dem Innenleiter (28) eines in der benachbarten Kammer (4) ausgebildeten Koaxialleiters (28, 29) verlaufen und mit dem anderen Ende (33) durch die Übertragungswand (7'') hindurch in die Behandlungskammer (6) ragen und dort mit Abstand zu einer gemeinsamen, auf dem Potential des Außenleiters (29) liegenden Gegenelektrode (35) angeordnet sind.

24. Hochfrequenzgerät nach Anspruch 23, **dadurch gekennzeichnet, daß** die durch die Übertragungswand (7'') ragenden Antennenelemente (10') parallel zur Gegenelektrode (35) ausgebildete Endstücke (34) aufweisen.

25. Hochfrequenzgerät nach Anspruch 23 oder 24, **dadurch gekennzeichnet, daß** die Antennenelemente (10') durch Durchgangskammern (12') aus leitendem Material (13') hindurchgeführt sind.

26. Hochfrequenz- oder Mikrowellengerät nach einem der Ansprüche 1 bis 25, **dadurch gekennzeichnet, daß** die Behandlungskammer (6) als Vakuumkammer ausgebildet ist.

27. Hochfrequenz- oder Mikrowellengerät nach einem der Ansprüche 1 bis 26, **dadurch gekennzeichnet, daß** innerhalb der Behandlungskammer (6) ein Behandlungstisch (24) höhenverstellbar ausgebildet ist.

28. Hochfrequenz- oder Mikrowellengerät nach einem der Ansprüche 1 bis 27, **dadurch gekennzeichnet, daß** an der Außenseite der Behandlungskammer (6) Spulenanordnungen (22) zur Ausbildung eines Magnetfeldes vorgesehen sind.

29. Hochfrequenz- oder Mikrowellengerät nach einem der Ansprüche 1 bis 28, **dadurch gekennzeichnet, daß** in der Behandlungskammer (6) eine Anordnung einer Mehrzahl von Permanent-Magneten (25) angeordnet ist.

30. Hochfrequenz- oder Mikrowellengerät nach einem der Ansprüche 1 bis 29, **gekennzeichnet durch** ein zwischen dem Behandlungstisch (24) und der Übertragungswand (7, 7') angeordnetes Sieb (23) als Elektronenfalle.

31. Verwendung des Hochfrequenz- oder Mikrowellengeräts nach einem der Ansprüche 1 bis 30 zur Ausbildung eines Plasmas in der Behandlungskammer (6).

## Claims

1. Electromagnetic high-frequency or microwave apparatus having a treatment chamber (6) with a transmission wall (7, 7', 7"), permeable to the electromagnetic waves, to a neighbouring chamber (4), in which the electromagnetic waves generated by a generator are conducted, and with a design of the transmission wall (7, 7', 7") for influencing the intensity distribution of the transmission of the electromagnetic waves from the neighbouring chamber (4) into the treatment chamber (6), **characterised in that** the transmission wall (7, 7', 7") has a multiplicity of rod-shaped antenna elements (10, 10') which are directed at an angle to the wall plane of the neighbouring chamber (4), project into the neighbouring chamber (4) and reach centrically through through-openings (14, 14') bounded by electrically conductive material.

2. Microwave apparatus according to Claim 1, **characterised in that** the transmission wall (7, 7') has a microwave-permeable plate (9) and a plate (11) made of electrically conductive material, in which the through-openings (14) are located.

3. Microwave apparatus according to Claim 2, **characterised in that** a common intermediate space (26) is formed between the through-openings (14) and the microwave-permeable plate (9).

4. Microwave apparatus according to Claim 2, **characterised in that** through-chambers (12) are formed between through-openings (14) and the microwave-permeable plate (9).

5. Microwave apparatus according to Claim 4, **characterised in that** a common intermediate space (27) is formed between the through-chambers (12) and the microwave-permeable plate (9).

6. Microwave apparatus according to one of Claims 2 to 5, **characterised in that** the antenna elements (10) are perpendicular to the permeable plate (9).

7. Microwave apparatus according to either of Claims 4 and 5, **characterised in that** the through-chambers (12) have, at that surface of the conductive material (11) which faces the neighbouring chamber (4), a circular through-opening (14) with a diameter (D) which is greater than the diameter (d) of the antenna element (10).

8. Microwave apparatus according to Claim 7, **characterised in that** the diameter (D) of the through-opening (14) is about 2 to 5, preferably about 3, times greater than the diameter (d) of the antenna element (10).

9. Microwave apparatus according to Claim 7 or 8, **characterised in that** the through-chambers (12) widen in the form of a step adjacent to the through-opening (14) on the side facing the permeable plate (9).

10. Microwave apparatus according to one of Claims 7 to 9, **characterised in that** the through-chamber (12) has a rectangular, preferably square, cross-section adjacent to the through-opening (14).

11. Microwave apparatus according to one of Claims 4 to 10, **characterised in that** the through-chambers (12) are formed in a common electrically conductive plate (11).

12. Microwave apparatus according to one of Claims 4 to 11, **characterised in that** the antenna elements (10) project out of the surface of the through-chambers (12).

13. Microwave apparatus according to one of Claims 1 to 12, **characterised in that** the lengths of various antenna elements (10) differ over the area of the transmission wall (7).

14. Microwave apparatus according to one of Claims 4 to 13, **characterised in that** the through-openings (14) are adjoined by coupling chambers (19), designed as further through-chambers, which each, centrically, have a coupling antenna element (21) and into which a plurality of antenna elements (10) project.

15. Microwave apparatus according to Claim 14, **characterised in that** the coupling chambers (19) also have a circular through-opening (20) at their surface which faces the neighbouring chamber (4).

16. Microwave apparatus according to Claim 15, **characterised in that** the coupling antenna elements (21) are designed with different lengths and project out of their through-openings (20).

17. Microwave apparatus according to one of Claims 1 to 16, **characterised in that** the neighbouring chamber (4), as the transmission chamber, has a longitudinal axis running parallel to the transmission wall (7) and at least one waveguide (3) directed parallel to the longitudinal axis for coupling microwaves into the transmission chamber (4).

18. Microwave apparatus according to Claim 17, **characterised in that** the waveguide (3) is of bar-shaped design and reaches through an opening (2) in a separating wall into a hollow waveguide (1), the longitudinal axis of which is perpendicular to the longitudinal axis of the transmission chamber (4).

19. Microwave apparatus according to Claim 17 or 18, **characterised in that** the waveguide (3) ends at a distance from the end wall located opposite the hollow waveguide (1) and **in that** the distance from the electrically effective end wall can be varied by a displaceable conductive plunger (15).

20. Microwave apparatus according to one of Claims 17 to 19, **characterised in that** a plurality of waveguides (3) project, parallel to one another, into the transmission chamber (4) and **in that** the waveguides (3) are assigned compartments (17) by means of conductive intermediate walls (16).

21. Microwave apparatus according to Claim 20, **characterised in that** each waveguide (3) is assigned symmetrical arrangements of antenna elements (10) within the compartments (17).

22. Microwave apparatus according to Claim 20 or 21, **characterised in that** a plunger (15) acting as an end wall is displaceably arranged within each of the compartments (17).

23. High-frequency apparatus according to Claim 1, **characterised in that** the antenna elements (10') are angled, one angled end (30) thereof running substantially parallel to the inner conductor (28) of a coaxial conductor (28, 29) formed in the neighbouring chamber (4) and the other end (33) thereof reaching through the transmission wall (7") into the treatment chamber (6) and being arranged therein at a distance from a common counterelectrode (35) which is at the potential of the outer conductor (29).

24. High-frequency apparatus according to Claim 23, **characterised in that** the antenna elements (10') reaching through the transmission wall (7") have end pieces (34) formed parallel to the counterelectrode (35).

25. High-frequency apparatus according to Claim 23 or 24, **characterised in that** the antenna elements (10') are passed through through-chambers (12') made of conductive material (13').

26. High-frequency or microwave apparatus according to one of Claims 1 to 25, **characterised in that** the treatment chamber (6) is designed as a vacuum chamber.

27. High-frequency or microwave apparatus according to one of Claims 1 to 26, **characterised in that** a treatment table (24) is designed to be height-adjustable within the treatment chamber (6).

28. High-frequency or microwave apparatus according to one of Claims 1 to 27, **characterised in that** coil arrangements (22) for producing a magnetic field are provided on the outside of the treatment chamber (6).

29. High-frequency or microwave apparatus according to one of Claims 1 to 28, **characterised in that** an arrangement of a plurality of permanent magnets (25) is arranged in the treatment chamber (6).

30. High-frequency or microwave apparatus according to one of Claims 1 to 29, **characterised by** a filter (23), arranged between the treatment table (24) and the transmission wall (7, 7'), as an electron trap.

31. Use of the high-frequency or microwave apparatus according to one of Claims 1 to 30 for producing a plasma in the treatment chamber (6).

## Revendications

1. Appareil à micro-ondes ou à haute fréquence électromagnétique comprenant une chambre de traitement (6) avec une paroi de transmission perméable aux ondes électromagnétiques (7,7',7") donnant sur une chambre voisine (4) dans laquelle sont conduites les ondes électromagnétiques produites par un générateur, et comportant un agencement de la paroi de transmission (7,7',7") pour influencer la répartition d'intensité de la transmission des ondes électromagnétiques allant de la chambre voisine (4) à la chambre de traitement (6), **caractérisé en ce que** la paroi de transmission (7,7',7") présente de multiples éléments d'antennes en forme de tiges (10,10') dirigés avec un angle par rapport au plan de paroi de la chambre voisine (4) et saillant dans la chambre voisine (4), qui font saillie en position centrale à travers des ouvertures de passage (14,14') délimitées par un matériau électriquement conducteur.

2. Appareil à micro-ondes selon la revendication 1, **caractérisé en ce que** la paroi de transmission (7,7') comporte une plaque (9) perméable aux micro-ondes et une plaque (11) en matériau électriquement conducteur, dans laquelle se trouvent les ouvertures de passage (14).

3. Appareil à micro-ondes selon la revendication 2, **caractérisé en ce qu'**un espace intermédiaire commun (26) est ménagé entre les ouvertures de passage (14) et la plaque (9) perméable aux micro-ondes.

4. Appareil à micro-ondes selon la revendication 2, **caractérisé en ce que** des chambres de passage (12) sont agencées entre les ouvertures de passage (14) et la plaque (9) perméable aux micro-ondes.

5. Appareil à micro-ondes selon la revendication 4, **caractérisé en qu'**un espace intermédiaire commun (27) est agencé entre les chambres de passage (12) et la plaque (9) perméable aux micro-ondes.

6. Appareil à micro-ondes selon l'une des revendications 2 à 5, **caractérisé en ce que** les éléments d'antenne (10) s'étendent perpendiculairement à la plaque perméable (9).

7. Appareil à micro-ondes selon l'une des revendications 4 ou 5, **caractérisé en ce que** les chambres de passage (12) présentent sur la surface du matériau conducteur (11) tournée vers la chambre voisine (4) une ouverture de passage circulaire (14) dont un diamètre (D) est plus grand que le diamètre (d) de l'élément d'antenne (10).

8. Appareil à micro-ondes selon la revendication 7, **caractérisé en ce que** le diamètre (D) de l'ouverture de passage (14) est environ 2 à 5 fois, de préférence trois fois plus grand que le diamètre (d) de l'élément d'antenne (10).

9. Appareil à micro-ondes selon la revendication 7 ou 8
**caractérisé en ce que** les chambres de passage (12) s'élargissent par épaulement à partir de l'ouverture de passage (14) vers la plaque perméable (9).

10. Appareil à micro-ondes selon l'une des revendications 7 à 9, **caractérisé en ce que** la chambre de passage (12) présente à partir de l'ouverture de passage (14) une section rectangulaire, de préférence carrée.

11. Appareil à micro-ondes selon l'une des revendications 4 à 10, **caractérisé en ce que** les chambres de passage (12) sont aménagées dans une plaque (11) électriquement conductrice commune.

12. Appareil à micro-ondes selon l'une des revendications 4 à 11, **caractérisé en ce que** les éléments d'antenne (10) font saillie de la surface des chambres de passage (12).

13. Appareil à micro-ondes selon l'une des revendications 1 à 12, **caractérisé en ce que** la longueur de différents éléments d'antenne (10) est réalisée différente sur la surface de la paroi de transmission (7).

14. Appareil à micro-ondes selon l'une des revendications 4 à 13, **caractérisé en ce qu'**aux ouvertures de passage (14) sont raccordées des chambres de couplage (19) réalisées comme d'autres chambres de passage, et qui présentent chacune en position centrale un élément d'antenne de couplage (21) et dans lesquelles pointent plusieurs éléments d'antenne (10).

15. Appareil à micro-ondes selon la revendication 14, **caractérisé en ce que** les chambres de couplage (19) présentent elles aussi sur leur surface tournée vers la chambre voisine (4) une ouverture de passage circulaire (20).

16. Appareil à micro-ondes selon la revendication 15, **caractérisé en ce que** les éléments d'antenne de couplage (21) sont réalisés avec des longueurs différentes et dépassent de leur ouverture de passage (20).

17. Appareil à micro-ondes selon l'une des revendications 1 à 16, **caractérisé en ce que** la chambre voisine (4) présente en tant que chambre de transmission un axe longitudinal s'étendant parallèlement à la paroi de transmission (7) et au moins un guide d'ondes (3) dirigé parallèlement à l'axe longitudinal pour l'injection de micro-ondes dans la chambre de transmission (4).

18. Appareil à micro-ondes selon la revendication 17, **caractérisé en ce que** le guide d'ondes (3) est réalisé en forme de tige et fait saillie dans un conducteur creux (1) à travers une ouverture (2) d'une cloison, l'axe longitudinal du conducteur creux étant perpendiculaire à l'axe longitudinal de la chambre de transmission (4).

19. Appareil à micro-ondes selon la revendication 17 à 18, **caractérisé en ce que** le guide d'ondes (3) se termine à distance de la paroi frontale opposée au conducteur creux (1), et **en ce que** la distance à la paroi frontale électriquement efficace peut être modifiée au moyen d'un plongeur conducteur déplaçable (15).

20. Appareil à micro-ondes selon l'une des revendications 17 à 19, **caractérisé en ce que** plusieurs guides d'ondes (3) font saillie dans la chambre de transmission (4) et **en ce qu'**aux guides d'ondes (3) sont associés des compartiments (17) au moyen de parois intermédiaires conductrices (16).

21. Appareil à micro-ondes selon la revendication 20 **caractérisé en ce que** des agencements symétriques d'éléments d'antenne (10) sont associés à chaque guide d'ondes (3) à l'intérieur des compartiments (17).

22. Appareil à micro-ondes selon la revendication 20 ou 21, **caractérisé en ce qu'**un plongeur (15) formant paroi frontale est monté déplaçable dans chaque compartiment (17).

23. Appareil à haute fréquence selon la revendication 1, **caractérisé en ce que** les éléments d'antenne (10') sont cambrés et s'étendent par une extrémité cambrée (30) sensiblement parallèlement au conducteur intérieur (28) d'un conducteur coaxial (28,29) agencé dans la chambre voisine (4), et font saillie par l'autre extrémité (33) à travers la paroi de transmission (7") dans la chambre de traitement (6) et y sont disposés à distance d'une contre-électrode commune (35) mise au potentiel du conducteur extérieur (29).

24. Appareil à haute fréquence selon la revendication 23, **caractérisé en ce que** les éléments d'antenne (10') faisant saillie à travers la paroi de transmission (7") présentent des pièces d'extrémité (34) agencées parallèles à la contre-électrode (35).

25. Appareil à haute fréquence selon la revendication 23 ou 24, **caractérisé en ce que** les éléments d'antenne (10') traversent des chambres de passage (12') en matériau conducteur (13').

26. Appareil à micro-ondes ou haute fréquence selon l'une des revendications 1 à 25, **caractérisé en ce que** la chambre de traitement (6) est agencée en chambre à vide.

27. Appareil à micro-ondes ou haute fréquence selon l'une des revendications 1 à 26, **caractérisé en ce qu'**une table de traitement (24) est agencée réglable en hauteur dans la chambre de traitement (6).

28. Appareil à micro-ondes ou haute fréquence selon l'une des revendications 1 à 27, **caractérisé en ce qu'**il est prévu sur le coté extérieur de la chambre de traitement (6) des agencements de bobines (22) pour l'établissement d'un champ magnétique.

29. Appareil à micro-ondes ou haute fréquence selon l'une des revendications 1 à 28, **caractérisé en ce qu'**un agencement de multiples aimants permanents (25) est disposé dans la chambre de traitement (6).

30. Appareil à micro-ondes ou haute fréquence selon l'une des revendications 1 à 29, **caractérisé par** un filtre (23) formant piège à électrons, agencé entre la table de traitement (24) et la paroi de transmission (7,7').

31. Utilisation d'un appareil à micro-ondes ou à haute fréquence selon l'une des revendications 1 à 30 pour l'établissement d'un plasma dans la chambre de traitement (6).
